# EUROPÄISCHE PATENTANMELDUNG

(11) **EP 3 572 824 A1**
(43) Veröffentlichungstag der Anmeldung: **27.11.2019**
(21) Anmeldenummer: 18174359.2
(22) Anmeldetag: 25.05.2018
(51) Int. Cl.: G01R 33/56, G01R 33/561

(54) **OFF-RESONANZ-UNEMPFINDLICHE MAGNETRESONANZMESSUNG MIT DEPHASIER-GRADIENT**

(71) Anmelder: Siemens Healthcare GmbH, 91052 Erlangen (DE)
(72) Erfinder: Kluge, Thomas, 96114 Hirschaid (DE); Körzdörfer, Gregor, 91058 Erlangen (DE); Nittka, Mathias, 91083 Baiersdorf (DE); Speier, Peter, 91056 Erlangen (DE)

(57) **Zusammenfassung**

Der Erfindung liegt die Erkenntnis zugrunde, dass die transversale Magnetisierung nicht zuverlässig durch unbalancierte Gradientenmomente, wie sie z.B. in schicht-selektiven (2D) FISP-Verfahren auftreten, ausreichend dephasiert wird. Dies führt zu einer B0-Abhängigkeit der aufgenommenen Messdaten. Ein erfindungsgemäßes Verfahren zur Erzeugung von Messdaten eines Untersuchungsobjektes mittels Magnetresonanztechnik, umfasst die Schritte:
- Innerhalb einer Wiederholzeit:
a) Einstrahlen eines RF-Anregungspulses (RFi, RFi+1, RFi+2, RFi+3, RFi+4) in das Untersuchungsobjekt,
b) Schalten eines Schichtselektionsgradienten (GS1) während der RF-Anregungspuls (RFi, RFi+1, RFi+2, RFi+3, RFi+4) eingestrahlt wird,
c) Schalten von weiteren Gradienten (GP1, GR2) zur Ortskodierung,
d) Aufnehmen eines nach dem RF-Anregungspuls (RFi, RFi+1, RFi+2, RFi+3, RFi+4) erzeugten Echosignals (Ei) als Messdaten (MDi),

- Wiederholen der Schritte a) bis d) bis eine gewünschte Anzahl an RF-Anregungspulsen eingestrahlt wurde,
wobei jeweils ein zusätzlicher dedizierter Dephasier-Gradient (G*, GS*, GR*) geschaltet wird, derart, dass eine transversale Magnetisierung der durch einen RF-Anregungspuls (RFi, RFi+1, RFi+2, RFi+3, RFi+4) anzuregenden Spins vor jedem eingestrahlten RF-Anregungspuls (RFi, RFi+1, RFi+2, RFi+3, RFi+4) ausreichend dephasiert ist.

## Beschreibung

Die Erfindung betrifft eine Off-Resonanz-unempfindliche Magnetresonanzmessung, insbesondere zur Verwendung in schicht-selektiven Magnetresonanz-Fingerprinting-Verfahren.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Eine Magnetresonanz-Bildgebung mittels einer Magnetresonanzanlage kann dazu dienen, eine Anwesenheit und/oder eine Verteilung eines Stoffs, welcher sich in einem Untersuchungsobjekt befindet, zu bestimmen. Der Stoff kann dabei beispielsweise ein, möglicherweise pathologisches, Gewebe des Untersuchungsobjekts, ein Kontrastmittel, eine Markierungssubstanz oder ein Stoffwechselprodukt sein.

Informationen über die vorliegenden Stoffe können dabei auf vielfältige Weise aus den aufgenommenen Messdaten gewonnen werden. Eine relativ einfache Informationsquelle sind z.B. aus den Messdaten rekonstruierte Bilddaten. Es gibt jedoch auch komplexere Verfahren, die, z.B. aus Bildpunkt-Zeit-Serien von aus sukzessive gemessenen Messdatensätzen rekonstruierten Bilddaten, Informationen über das untersuchte Untersuchungsobjekt ermitteln.

Mit Hilfe von quantitativen MR-Bildgebungstechniken lassen sich absolute Eigenschaften des gemessenen Objekts bestimmen, am Menschen z.B. die gewebespezifische T1- und T2-Relaxation. Im Gegensatz dazu erzeugen die in der klinischen Routine meist verwendeten konventionellen Sequenzen lediglich eine relative Signalintensität unterschiedlicher Gewebetypen (sogenannte Wichtungen), so dass die diagnostische Interpretation in hohem Maße der subjektiven Einschätzung des Radiologen unterliegt. Quantitative Techniken bieten somit den offensichtlichen Vorteil einer objektiven Vergleichbarkeit, finden aber aufgrund langer Messzeiten derzeit in der Routine kaum Verwendung.

Neuere quantitative Messverfahren wie Magnetresonanz-Fingerprinting-Verfahren (MRF-Verfahren), könnten den genannten Nachteil der langen Messzeiten auf ein akzeptables Maß senken. Bei MRF-Verfahren werden Signalverläufe von aus zeitlich nacheinander mit verschiedenen Aufnahmeparametern aufgenommenen Messdaten rekonstruierten Bilddaten mittels Mustererkennungsverfahren ("pattern recognition") mit Signalverläufen einer zuvor ermittelten Datenbank von für bestimmte Stoffe charakteristischen Signalverläufen (dem sogenannten "Dictionary") verglichen, um die in den aus den Messdaten rekonstruierten Bilddaten repräsentierten Stoffe bzw. die räumliche Verteilung von gewebespezifischen Parametern (wie die Transversalrelaxation T2 oder die Longitudinalrelaxation T1; sogenannte T1- und T2-Karten) in dem abgebildeten Untersuchungsobjekt zu ermitteln. Die in einem derartigen Dictionary enthaltenen Signalverläufe können hierbei auch durch Simulationen erstellt worden sein. Das Prinzip dieser Methode ist somit, gemessene Signalverläufe mit einer Vielzahl im Voraus bekannter Signalverläufe zu vergleichen. Dabei können Signalverläufe für verschiedene Kombinationen aus T1- und T2-Relaxationszeiten für das Dictionary ermittelt worden sein. Die T1- und T2-Zeiten eines Bildpunktes (Pixels) im Bild werden dann insbesondere bestimmt, indem der gemessene Signalverlauf mit allen simulierten Signalverläufen verglichen wird. Dieser Vorgang wird als "Matching" bezeichnet. Derjenige Signalverlauf des Dictionarys, der dem gemessenen Signalverlauf am ähnlichsten ist, determiniert die Relaxationsparameter T1 und T2 des jeweiligen Bildpunktes.

Magnetresonanz-Fingerprinting-Verfahren sind beispielsweise in dem Artikel von Ma et al., "Magnetic Resonance Fingerprinting", Nature, 495: S. 187-192 (2013) und dem Artikel von Jiang et al., ,,"MR Fingerprinting Using Fast Imaging with Steady State Precession (FISP) with Spiral Readout", Magnetic Resonance in Medicine 74: S. 1621-1631 (2015) bekannt.

Für MRF-Verfahren kann grundsätzlich jede Echotechnik in Kombination mit jeglichem Verfahren zur k-Raum Abtastung (kartesisch, spiralförmig, radial) benutzt werden.

Derzeit wird bevorzugt eine "Fast Imaging with Steady-state Precession" (FISP) Sequenz in Kombination mit einer Spiral-Abtastung benutzt, wie sie z.B. in dem genannten Artikel von Jiang et al. beschrieben ist: Nach einem adiabatischen 180° RF-Inversionspuls zur gezielten Störung des Gleichgewichtzustandes der Spins wird eine Folge von RF-Anregungspulsen mit pseudorandomisierten Flipwinkeln appliziert und jedes jeweils nach einem der RF-Anregungspulse resultierende Echo mit einer einzelnen spiralförmigen k-Raumtrajektorie ausgelesen. Es werden n RF-Anregungspulse benutzt, die ebenso viele Echos erzeugen. Aus den entlang der jeweiligen k-Raumtrajektorie aufgenommenen Messdaten jedes Echos wird ein Einzelbild rekonstruiert. Aus den n Einzelbildern wird für jeden Bildpunkt ein Signalverlauf extrahiert, der mit den simulierten Verläufen verglichen wird. Der zeitliche Abstand TR zwischen zwei aufeinanderfolgenden RF-Anregungspulsen der n RF-Anregungspulse kann hierbei ebenfalls, z.B. pseudorandomisiert, variiert werden.

FISP Sequenzen, die auch als GRASS ("Gradient Recalled Acquisition into Steady State") oder T2-FFE ("Fast Field Echo, T2-weighted")-Sequenzen bezeichnet werden, gelten im Gegensatz zu TrueFISP Sequenzen, bei welchen die Schichtselektionsgradienten balanciert sind (d.h. das nullte Moment der Schichtselektionsgradienten ist Null), als deutlich weniger empfindlich auf Variationen des statischen Magnetfelds B0. Die FISP-MRF Implementierung löste vorrangig aus diesem Grund das TrueFISP-basierte, in dem bereits genannten Artikel von Ma et al. beschriebene "Original", TrueFISP-MRF, ab. Auf Grund unbalancierter Gradientenmomente innerhalb jedes TRs, also zwischen zwei aufeinanderfolgenden RF-Anregungspulsen, wird bei FISP-MRF davon ausgegangen, dass die Magnetisierung vollständig dephasiert ist, bevor ein nächster RF-Anregungspuls die Magnetisierung kippt. In dem bereits genannten Artikel von Jiang et al. wird angegeben, dass das durch den dort verwendeten unbalancierten Schichtselektionsgradienten erzeugte Dephasierungsmoment ausreicht, um eine B0-Abhängigkeit des gemessenen Echosignals vernachlässigen zu können.

Der Erfindung liegt die Aufgabe zugrunde, MRF-Messungen zu ermöglichen, deren Ergebnisse tatsächlich von off-Resonanzen unabhängig sind.

Die Aufgabe wird gelöst durch ein Verfahren zur Erzeugung von Messdaten eines Untersuchungsobjektes mittels Magnetresonanztechnik gemäß Anspruch 1, eine Magnetresonanzanlage gemäß Anspruch 13, ein Computerprogramm gemäß Anspruch 14, sowie einen elektronisch lesbaren Datenträger gemäß Anspruch 15.

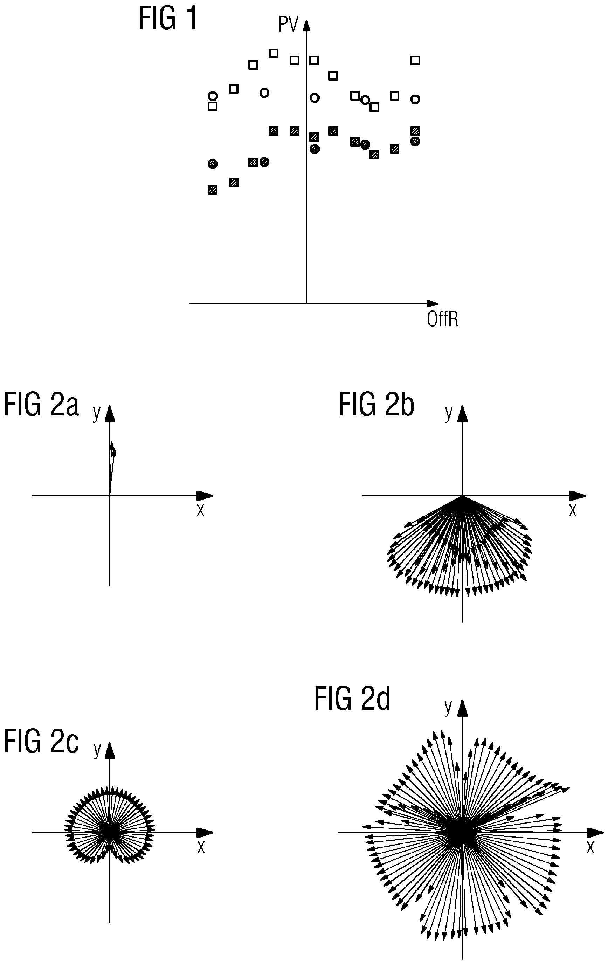

Der Erfindung liegen folgende Erkenntnisse zugrunde:
Wie im Folgenden mit Bezug auf die Figuren 1 bis 3 weiter ausgeführt wird, wurde festgestellt, dass es nicht wie bisher angenommen immer der Fall ist, dass die transversale Magnetisierung durch unbalancierten Gradientenmomente, wie sie z.B. in schicht-selektiven (2D) FISP-Verfahren auftreten, nicht vollständig dephasiert wird. Stattdessen wurde festgestellt, dass es für schicht-selektive (2D) MRF-Verfahren zu Off-Resonanz bedingten Signal-Modulationen kommt, die die Ergebnisse von MRF-Verfahren signifikant verfälschen können, und somit doch eine nicht zu vernachlässigende B0-Abhängigkeit vorliegt. Weiter wurde festgestellt, dass es zur Vermeidung dieser B0-Abhängigkeit nicht ausreichend ist, "irgendeine" weitere Dephasierung der transversalen Magnetisierung herbeizuführen, sondern eine dedizierte Dephasierung nötig ist, um Artefakte in den Ergebnissen zu vermeiden.

Ein erfindungsgemäßes Verfahren zur Erzeugung von Messdaten eines Untersuchungsobjektes mittels Magnetresonanztechnik, umfasst die Schritte:
- Innerhalb einer Wiederholzeit:
   a) Einstrahlen eines RF-Anregungspulses in das Untersuchungsobjekt,
   b) Schalten eines Schichtselektionsgradienten während der RF-Anregungspuls eingestrahlt wird,
   c) Schalten von weiteren Gradienten zur Ortskodierung,
   d) Aufnehmen eines nach dem RF-Anregungspuls erzeugten Echosignals als Messdaten,
- Wiederholen der Schritte a) bis d) bis eine gewünschte Anzahl an RF-Anregungspulsen eingestrahlt wurde,
wobei jeweils ein zusätzlicher dedizierter Dephasier-Gradient geschaltet wird, derart, dass eine transversale Magnetisierung der durch einen RF-Anregungspuls anzuregenden Spins vor jedem eingestrahlten RF-Anregungspuls dephasiert ist.

Durch die Schaltung von erfindungsgemäßen dedizierten Dephasier-Gradienten wird eine B0-Abhängigkeit der aufgenommenen Messdaten vermieden. Dedizierte Dephasier-Gradienten erlauben somit eine Unabhängigkeit von Off-Resonanzen, wie sie insbesondere bei Inhomogenitäten des B0-Feldes auftreten, wobei sie gleichzeitig so ausgestaltet sind, dass sie keine Diffusionseffekte erzeugen. Der dedizierte Dephasier-Gradient sorgt hierbei für eine ausreichende Dephasierung der durch einen RF-Anregungspuls anzuregenden Spins vor jedem eingestrahlten RF-Anregungspuls, sodass zum Zeitpunkt einer Anregung durch einen RF-Anregungspuls allenfalls noch vernachlässigbare Anteile einer vorhergehenden transversalen Magnetisierung bestehen bleiben. Insbesondere werden die Spins durch den dedizierten Dephasier-Gradienten vollständig dephasiert.

Die Echosignale, die als Messdaten aufgenommen werden, können gemäß einem FISP-Sequenzschema erzeugt werden. Die FISP-Sequenz wird bereits häufig für MRF-Verfahren eingesetzt, und kann ohne großen Aufwand modifiziert werden, um erfindungsgemäße dedizierte Dephasier-Gradienten zu umfassen.

Erfindungsgemäße dedizierte Dephasier-Gradienten können durch Simulationen, insbesondere Bloch-Simulationen, bestimmt werden, z.B. indem das Verhalten verschiedener Dephasier-Gradienten-Kandidaten bei Variation gewählter Off-Resonanzen verglichen wird. Simulationen sind kostengünstig durchführbar und benötigen weder das Benutzten einer Magnetresonanzanlage noch ein reales Untersuchungsobjekt.

Durch eine derartige Simulation bestimmte dedizierte Dephasier-Gradienten können weiter experimentell, z.B. mit Hilfe von Phantomen oder auch an Probanden, überprüft und, sollten z.B. noch keine zufriedenstellenden Ergebnisse erreicht worden sein, angepasst werden. Insbesondere in Fällen, in denen die simulierten Bedingungen unangemessen von den realen Messbedingungen abweichen, kann eine solche Überprüfung durchgeführt werden. Weiter kann eine solche Überprüfung helfen, die Simulation zu verbessern.

Es ist auch denkbar die dedizierten Dephasier-Gradienten rein experimentell zu bestimmen, indem z.B. wieder das Verhalten verschiedener Dephasier-Gradienten-Kandidaten unter Variation einer bei der Messung verwendeten Off-Resonanz verglichen wird. Auf diese Weise erhaltene dedizierte Dephasier-Gradienten sind besonders gut an die realen Bedingungen der Magnetresonanzanlage angepasst, an der sie bestimmt wurden.

Bei derartigen Vergleich von Simulationen oder experimentellen Ergebnissen kann z.B. ein Optimierungsverfahren zur Ermittlung des optimalen dedizierten Dephasier-Gradienten unter Verwendung der Ergebnisse der Dephasier-Gradienten-Kandidaten eingesetzt werden, das insbesondere denjenigen Dephasier-Gradient bestimmt, der die geringste BO-Abhängigkeit der Messdaten, ggf. unter Berücksichtigung von den erzeugten Lasten auf das Gradientensystem, bewirkt.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung mit einer Multi-Band-RF-Pulseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 beispielhafte Ergebnisse von mittels MRF ermittelten Parameterwerten, deren zugrundeliegende Bilderserie unter Anwendung verschiedener Off-Resonanzen und mit und ohne zusätzlichen Dephasier-Gradienten erstellt wurde, im Vergleich,
Fig. 2a-2d beispielhafte Simulationen einer transversalen Magnetisierung mit verschiedenen Off-Resonanzen und mit und ohne dediziertem Dephasier-Gradienten im Vergleich,
Fig. 3 Wirkungen verschiedener zusätzlicher Dephasier-Gradienten,
Fig. 4 ein schematisches Ablaufdiagramm eines erfindungsgemäßen Verfahrens,
Fig. 5 ein Beispiel eines Pulssequenzschemas, wie es für das erfindungsgemäße Verfahren eingesetzt werden kann,
Fig. 6 einen größeren Ausschnitt eines allgemeineren Pulssequenzschemas, wie es für das erfindungsgemäße Verfahren eingesetzt werden kann,
Fig. 7 eine schematisch dargestellte erfindungsgemäße Magnetresonanzanlage.

Figur 1 zeigt beispielhafte Ergebnisse von mittels MRF ermittelten Parameterwerten PV, z.B. T1- oder T2-Werte, deren zugrundeliegende Bilderserie unter Anwendung verschiedener Off-Resonanzen OffR und mit und ohne zusätzlichen dedizierten Dephasier-Gradienten bei der Aufnahme der Messdaten erstellt wurde, im Vergleich.

Die quadratisch dargestellten Werte sind hierbei mittels MRF-Verfahren auf Grundlage von Bildserien ermittelt worden, die aus Messdaten rekonstruiert wurden, die Echosignalen entsprechen, die ohne zusätzlichen dedizierten Dephasier-Gradienten ausgelesen wurden; die kreisförmig dargestellten Werte basieren auf mit zusätzlichem dedizierten Dephasier-Gradient aufgenommenen Messdaten. Die schraffiert dargestellten Werte sind dabei aus einem interessierenden Bereich (ROI; engl. "region of interest") des Untersuchungsobjektes entnommen, die ungefüllt dargestellten aus einem andern ROI des Untersuchungsobjekts.

Wie man sehen kann, schwanken in jedem der dargestellten ROIs die erhaltenen Parameterwerte, die auf Messdaten beruhen, die ohne zusätzlichen Dephasier-Gradienten aufgenommen wurden (Quadrate), mit unterschiedlichen Off-Resonanzen deutlich mehr, als die, die auf Messdaten beruhen, die mit zusätzlichem Dephasier-Gradient gemessen wurden (Kreise).

Somit veranschaulicht die Figur 1 die ohne zusätzlichen Dephasier-Gradienten bei der Aufnahme der Messdaten doch vorhandene Abhängigkeit der Messdaten und damit der auf Grundlage dieser ermittelten Parameterwerte PV von Off-Resonanzen. In realen Systemen entstehen derartige Off-Resonanzen ungewollt durch Inhomogenitäten des B0-Feldes, da das lokal herrschende B0-Feld direkt proportional zu der Resonanzfrequenz der lokalen Spins ist.

Durch testen (per Simulation oder experimentell) verschiedener zusätzlicher Dephasier-Gradienten kann derjenige Dephasier-Gradient ermittelt werden, mit dem die auf Grundlage der Messwerte ermittelten Parameterwerte PV möglichst keine Abhängigkeit mehr von Off-Resonanzen OffR zeigen.

In den Figuren 2a, 2b, 2c und 2d sind beispielhafte Simulationen einer transversalen Magnetisierung mit verschiedenen Off-Resonanzen und mit und ohne dediziertem Dephasier-Gradienten im Vergleich dargestellt.

Auf der linken Seite, 2a und 2c, ist die simulierte transversale Magnetisierung zum Zeitpunkt eines ersten RF-Anregungspulses von insgesamt N RF-Anregungspulsen dargestellt, auf der rechten Seite, 2b und 2d, zum Vergleich die simulierte transversale Magnetisierung zum Zeitpunkt eines 500. RF-Anregungspulses von insgesamt N RF-Anregungspulsen in N Wiederholungen.

Oben, 2a und 2b, wurde die transversale Magnetisierung ohne zusätzlichen dedizierten Dephasier-Gradienten simuliert, unten, 2c und 2d, enthielt die Simulation einen zusätzlichen dedizierten Dephasier-Gradienten.

Wie man sieht, ist die transversale Magnetisierung ohne zusätzlichen dedizierten Dephasier-Gradienten bereits bei dem ersten RF-Anregungspuls (im Beispiel ist eine mittlere transversale Magnetisierung in y-Richtung zu sehen) und auch bei späteren RF-Anregungspulsen nicht gleichmäßig verteilt, sodass sich die Magnetisierung nicht im Mittel aufhebt, sondern sich eine mittlere transversale Magnetisierung ergibt, die nicht Null ist. Dies veranschaulicht wieder, dass ohne dedizierten Dephasier-Gradienten die transversale Magnetisierung zu den Anregungszeitpunkten, bei Einstrahlung der RF-Anregungspulse nicht wie bisher angenommen Null ist. Im Vergleich dazu ist die transversale Magnetisierung mit zusätzlichem Dephasier-Gradienten deutlich gleichmäßiger Verteilt, sodass die transversale Magnetisierung im Mittel verschwindet.

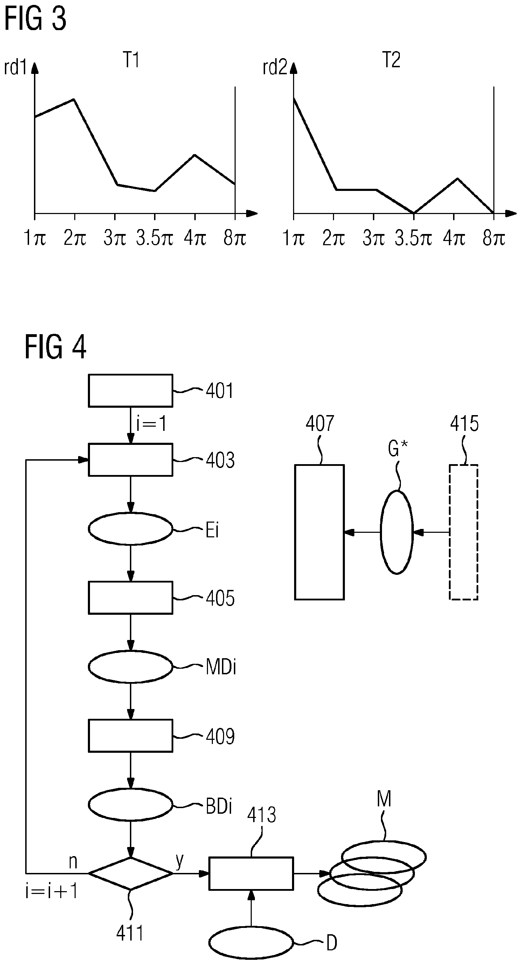

Figur 3 zeigt Wirkungen verschiedener zusätzlicher Dephasier-Gradienten.

Auf der linken Seite sind aus fünf Proben mit jeweils fünf verschiedenen Off-Resonanzen ermittelte relative Abweichungen rd1 von mittels MRF erstellten T1-Parameterwerten abgebildet, die jeweils auf Basis von Messwerten erstellt wurden, die mit verschiedenen Dephasier-Gradienten mit Dephasiermomenten zwischen In und 8π (Abszisse) gemessen wurden.

Auf der rechten Seite sind ebenfalls fünf Proben mit jeweils fünf verschiedenen Off-Resonanzen ermittelte relative Abweichungen rd2 von mittels MRF erstellten T2-Parameterwerten abgebildet, die auch jeweils auf Basis von Messwerten erstellt wurden, die mit verschiedenen Dephasier-Gradienten mit Dephasiermomenten zwischen In und 8π (Abszisse) gemessen wurden.

Je kleiner die relative Abweichung rd1 bzw. rd2 ist, desto weniger beeinflussen die verwendeten Off-Resonanzen das Ergebnis, und desto unabhängiger vom B0-Feld waren die zugrundeliegenden Messwerte.

In beiden Fällen ist ein grundsätzlicher Trend einer geringeren relativen Abweichung rd1 bzw. rd2 mit höherem Gradientenmoment festzustellen. Dieser Trend verläuft jedoch nicht wie erwartet monoton. Stattdessen wurde mit einem Dephasier-Gradienten mit einem Gradientenmoment von 3,5π eine vergleichbar gute B0-Unabhängigkeit erreicht wie mit einem Dephasier-Gradienten mit einem Gradientenmoment von 8π.

Dedizierte Dephasier-Gradienten sollten derart ermittelt werden, dass sie eine bestmögliche Unabhängigkeit der Messwerte von Off-Resonanzen erlauben. Gleichzeitig sollten sie derart ausgestaltet sein, dass sie möglichst keine Diffusionseffekte erzeugen, d.h. insbesondere, dass sie möglichst kleine Gradientenmomente haben.

In dem Beispiel der Figur 3 würde somit mit den genannten Bedingungen ein Dephasier-Gradient mit einem Gradientenmoment von 3,5π als anzuwendender erfindungsgemäßer dedizierter Dephasier-Gradient bestimmt werden können.

Figur 4 ist ein schematisches Ablaufdiagramm eines erfindungsgemäßen Verfahrens zur Erzeugung von Messdaten eines Untersuchungsobjektes mittels Magnetresonanztechnik.

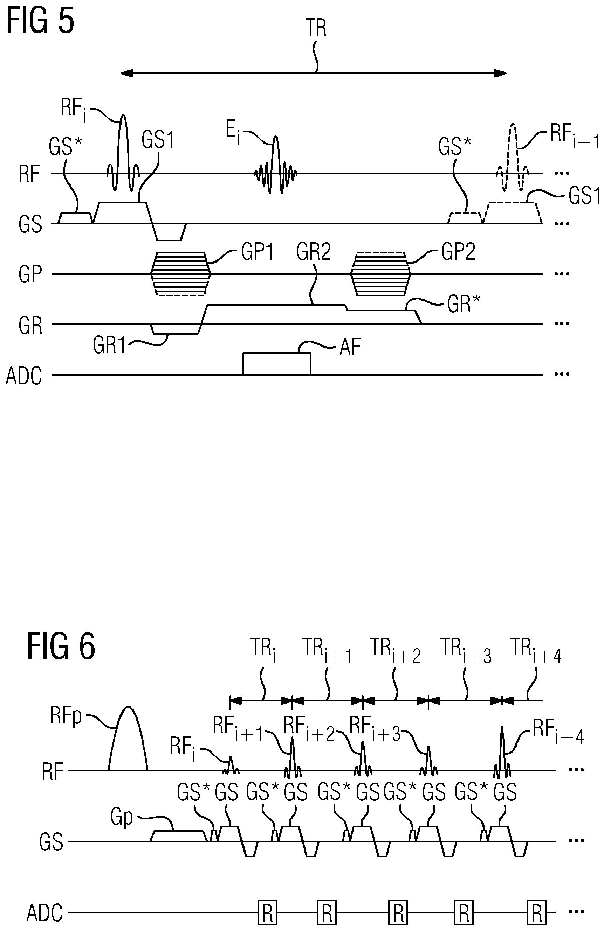

Dabei kann zunächst eine Präparation der Magnetisierung in dem zu untersuchenden Untersuchungsobjekt vorgenommen werden (Block 401). Hierbei kommt insbesondere eine Präparation wie sie weiter unten in Bezug auf Figur 6 beschrieben ist, in Frage.

Nach der möglichen Präparation wird ein erster (i=1) RF-Anregungspuls in das Untersuchungsobjekt eingestrahlt, während gleichzeitig ein Schichtselektionsgradient geschaltet ist (Block 403). Durch den RF-Anregungspuls wird ein Echosignal Ei erzeugt, dass als Messdaten MDi aufgenommen wird (Block 405).

Neben dem bereits genannten Schichtselektionsgradienten werden innerhalb einer Wiederholzeit (=Zeit zwischen zwei aufeinanderfolgenden RF-Anregungspulsen) weitere Gradienten, insbesondere zur Ortskodierung, geschaltet (Block 407). Erfindungsgemäß wird hierbei auch ein zusätzlicher dedizierter Dephasier-Gradient G* geschaltet, der derart wirkt, dass eine transversale Magnetisierung der durch einen RF-Anregungspuls anzuregender Spins zum Zeitpunkt des Einstrahlens jedes RF-Anregungspulses ausreichend, insbesondere vollständig, dephasiert ist.

In welche Richtung, zu welchem Zeitpunkt und mit welchem Gradientenmoment der zusätzliche dedizierte Dephasier-Gradient G* innerhalb einer Wiederholzeit TR geschaltet wird, kann z.B. mittels Simulation oder experimentell unter Berücksichtigung von Bedingungen, die z.B. durch die verwendete Hardware oder durch gewünschte Eigenschaften der aufgenommenen Messwerte vorgegeben sind, bestimmt werden (Block 415).

Aus den zu einem Echosignal Ei aufgenommenen Messdaten MDi können Bilddaten BDi rekonstruiert werden (Block 409). Dies kann auch zu einem späteren Zeitpunkt geschehen.

Wurden noch nicht alle gewünschten RF-Anregungspulse eingestrahlt (Abfrage 411, "n") wiederholt sich der Vorgang ab Block 403 mit dem einstrahlen eines nächsten RF-Anregungspulses (i=i+1).

Wurden bereits eine gewünschte Anzahl N an RF-Anregungspulsen eingestrahlt (Abfrage 411, "y"), endet die Messung.

Die erhaltene Folge von N Bilddaten BDi (i=1...N) kann mittels MRF-Verfahren mit Vergleichsdaten, beispielsweise einem sogenannten Dictionary, verglichen werden (Block 413), um für jeden Bildpunkt der Bilddaten quantitative Parameterwerte des Untersuchungsobjektes (z.B. T1-, T2- oder auch B0- oder B1-Werte) zu ermitteln, aus denen Parameterkarten M erstellt werden können.

In Figur 5 ist ein Beispiel eines Pulssequenzschemas dargestellt, wie es für das erfindungsgemäße Verfahren eingesetzt werden kann. In Pulssequenzschemata wird der zeitliche Verlauf und die zeitliche Koordination von einzustrahlenden RF-Pulsen und zu schaltenden Gradienten, sowie ggf. Aufnahmeaktivitäten (Auslesefenster) und Echosignalen veranschaulicht. In dem Beispiel der Figur 5 sind in der obersten Zeile Hochfrequenzsignale RF, in der zweiten Zeile die Gradientenschaltung in Schichtselektionsrichtung, in der dritten Zeile die Gradientenschaltung in Phasenkodierrichtung, in der vierten Zeile die Gradientenschaltung in Frequenzkodierrichtung (Ausleserichtung) und in der untersten Zeile die Auslesetätigkeit ADC dargestellt.

Ein RF-Anregungspuls RFi wird eingestrahlt, wobei gleichzeitig ein Schichtselektionsgradient GS1 geschaltet wird, um mit dem RF-Anregungspuls RFi nur Spins in einer durch den Schichtselektionsgradienten GS1 und den RF-Anregungspuls RFi festgelegten, gewünschten Schicht anzuregen.

Durch Schalten eines Gradienten in Ausleserichtung GR1 werden die angeregten Spins dephasiert, d.h. eine nach dem RF-Anregungspuls RFi vorhandene transversale Magnetisierung wird aufgefächert und zerfällt somit. Ein weiterer Gradient in Ausleserichtung GS2 sorgt durch seine im Vergleich zu der Polarisierung des ersten Gradienten in Ausleserichtung GS1 umgekehrte Polarisierung für eine Rephasierung der Spins, wodurch das Echosignal, ein sogenanntes Gradientenecho, entsteht, das während des geschalteten Gradienten GR2 in einem Auslesefenster AF aufgenommen wird, der somit für eine Frequenzkodierung der aufgenommenen Signale sorgt. Zur weiteren Ortskodierung wird nach dem RF-Anregungspuls RFi und vor Entstehung des Echosignals Ei ein Gradient in Phasenkodierrichtung GP1 geschaltet. In dem gezeigten Beispiel sind verschiedene mögliche Amplituden des Gradienten GP1 auf einmal dargestellt, die z.B. in aufeinanderfolgenden Wiederholungen der dargestellten Folge von RF-Pulsen und zu schaltenden Gradienten nach und nach angewendet werden können.

Nach dem Auslesen des Echosignals Ei können weitere Gradienten in Phasenkodierrichtung GP2 geschaltet werden. Diese weiteren Gradienten in Phasenkodierrichtung GP2 können insbesondere dieselbe Amplitude wie der vorhergehende Gradient in Phasenkodierrichtung GP1 aber eine umgekehrte Amplitude haben. Auf diese Weise wird eine mit dem ersten Gradienten in Phasenkodierrichtung GP1 erzeugte Phase der Spins wieder "zurückgedreht", sodass keine Phasenkodierung einer Wiederholung TR in die nachfolgende übernommen wird.

Nach einer Wiederholzeit TR wird ein nächster RF-Anregungspuls RFi+1, der auf dieselbe Art in Schichtrichtung durch einen Schichtselektionsgradienten GS1 selektiv gemacht ist, eingestrahlt und das Schema kann mit geänderter Ortskodierung, durch geänderte Gradienten in Phasenkodierrichtung, wiederholt werden bis alle gewünschten Messdaten aufgenommen wurden.

Soweit ist eine typische kartesische FISP-Sequenz beschrieben. Erfindungsgemäß wird jedoch zusätzlich ein dedizierter Dephasier-Gradient GS*,GR* geschaltet, der gezielt dafür sorgt, dass die transversale Magnetisierung der angeregten Spins ausreichend dephasiert ist, bevor ein nachfolgender RF-Anregungspuls RFi+1 eingestrahlt wird. Damit kann erreicht werden, dass die Ergebnisse der Messung nicht vom angelegten BO-Feld abhängen. Ein solcher dedizierter Dephasier-Gradient GS* kann in Schichtselektionsrichtung GS geschaltet werden. Mit typischerweise angeregten Schichtdicken von ca. 2 Millimetern, ist in Schichtrichtung die räumliche Auflösung in der Regel kleiner, als die räumliche Auflösung in der Ebene, die senkrecht auf die Schichtrichtung steht, in der typischerweise Bildpunkte mit ca. 0,5 Millimeter mal 0,5 Millimeter Kantenlängen aufgelöst werden. Daher kann mit einem Gradienten in Schichtselektionsrichtung eine stärkere Dephasierung der transversalen Magnetisierung erreicht werden, als mit einem gleich starken und gleich langen Gradienten in eine zu der Schichtselektionsrichtung orthogonalen Richtung. Dennoch kann es auch sinnvoll sein, in den dedizierten Dephasier-Gradienten in Ausleserichtung GR* und/oder Phasenkodierrichtung (nicht dargestellt) zu schalten. Dies kann z.B. eine gleichmäßigere Verteilung der Last auf die in die verschiedenen Richtungen wirkenden Gradientenspulen erleichtern. Es ist dabei auch denkbar, den dedizierten Dephasier-Gradienten GS*,GR* auf zwei oder alle drei Kodierungsrichtungen (Schichtselektions-, Phasenkodier- und Ausleserichtung) zu verteilen.

Grundsätzlich ist es hierbei sinnvoll, die Dephasier-Gradienten GS*,GR* mit einer gleichen Polarität zu schalten wie benachbarte Gradienten, die der Ortskodierung dienen. Auf diese Weise arbeiten die den Dephasier-Gradienten GS*,GR* benachbarten Gradienten nicht gegen die gewünschte Dephasierung, sondern tragen konstruktiv zu der gewünschten Dephasierung bei.

Dedizierte Dephasier-Gradienten können insbesondere in einem Zeitfenster nach einem Auslesefenster AF und vor dem nachfolgenden RF-Anregungspuls RFi+1 geschaltet werden. Dadurch wird ein Einfluss der dedizierten Dephasier-Gradienten auf die Ortskodierung der gemessenen Echosignale minimiert.

Figur 6 zeigt einen größeren Ausschnitt eines allgemeineren Pulssequenzschemas, wie es für das erfindungsgemäße Verfahren eingesetzt werden kann, dargestellt. Es sind hierbei in der oberen Zeile einzustrahlende RF-Pulse, in der zweiten Zeile in Schichtselektionsrichtung GS zu schaltende Gradienten und in der unteren Zeile die Auslesefenster "R", in denen die Messdatenaufnahme erfolgt, dargestellt. Gradienten, die in Phasenkodierrichtung und in Ausleserichtung (Frequenzkodierrichtung) geschaltet werden (hier nicht dargestellt) bestimmen die jeweiligen Zeitpunkte nach dem vorhergehenden RF-Anregungspuls RFi nach welchen ein Echosignal gebildet wird und die k-Raumtrajektorien gemäß derer die gebildeten Echosignale ausgelesen werden.

Dabei können Gradienten in Phasenkodierrichtung und Ausleserichtung derart geschaltet werden, dass eine den k-Raum spiralförmig abtastende FISP-Sequenz entsteht, wie sie z.B. in dem oben genannten Artikel von Jiang et al. beschrieben ist. Es ist auch denkbar, dass die Gradienten in Phasenkodierrichtung und Ausleserichtung derart geschaltet werden, dass eine den k-Raum kartesisch abtastende FISP-Sequenz entsteht, wie sie z.B. in Figur 5 beschrieben ist. Weiterhin ist es auch denkbar, dass die Gradienten in Phasenkodierrichtung und Ausleserichtung derart geschaltet werden, dass eine den k-Raum radial abtastende FISP-Sequenz entsteht. Entlang welcher k-Raumtrajektorien der k-Raum bei dem Auslesen der Echosignale abgetastet werden soll, kann z.B. von einer gewünschten Bewegungsinsensitivität, einer gewünschten Verteilung im k-Raum und/oder einer gewünschten Auflösung abhängig gemacht werden. Zur Vorbereitung der Messung kann z.B. ein Präparationspuls RFp in das Untersuchungsobjekt eingestrahlt werden, der die Magnetisierung in dem Untersuchungsobjekt auf eine gewünschte Weise manipuliert. Beispielsweise kann der Präparationspuls RFp ein Inversionspuls sein, der mögliche Gleichgewichtszustände der Magnetisierung stört. Im Anschluss an einen solchen Präparationspuls RFp kann zur weiteren Vorbereitung der Magnetisierung ein Präparationsgradient Gp geschaltet werden. Dieser Präparationsgradient Gp kann insbesondere dazu dienen eine möglicherweise nach dem Präparationspuls RFp noch vorhandene transversale Magnetisierung zu dephasieren und damit zu zerstören, sodass die folgenden Bestandteile der Pulssequenz nicht von einer bereits zuvor vorhandenen Magnetisierung negativ beeinflusst werden können.

Die Erzeugung von n Echosignalen, die in Auslesefenstern "R" als Messdaten aufgenommen werden, wird dann, wie bei MRF-Messungen üblich, durch Einstrahlen von N RF-Anregungspulsen RFi (i=1...N) und Schalten von Gradienten in Phasenkodierrichtung und Ausleserichtung durchgeführt. Dabei können insbesondere die Wiederholzeit TR und/oder der mit den verwendeten RF-Anregungspulsen RFi erzeugte Flipwinkel, um den eine Magnetisierung der Spins in dem Untersuchungsobjekt durch den eingestrahlten RF-Anregungspuls gekippt wird, variiert werden, wie es durch die unterschiedlichen Amplituden der RF-Anregungspulse und die unterschiedlichen Längen der Wiederholungszeiten TR skizziert ist.

Während jedes RF-Anregungspulses RFi wird ein Schichtselektionsgradient GS geschaltet, sodass die Echosignale in einer gewünschten Schicht des Untersuchungsobjektes erzeugt werden. Im Gegensatz zu dem aus dem genannten Artikel von Jiang et al. bekannten Pulssequenzschema sind jedoch erfindungsgemäße dedizierte Dephasier-Gradienten GS* in dem gezeigten Beispiel vor jedem RF-Anregungspuls RFi geschaltet, um die in den Auslesefenstern "R" aufgenommenen Messdaten wirklich unabhängig von B0-Feldinhomogenitäten zu machen. Die Dephasier-Gradienten GS*, GS1*, GS2* sind in allen Figuren nur beispielhaft dargestellt, und können auch anders ausgestaltet sein, beispielsweise an vorhergehende oder nachfolgenden Gradienten angeschlossen sein.

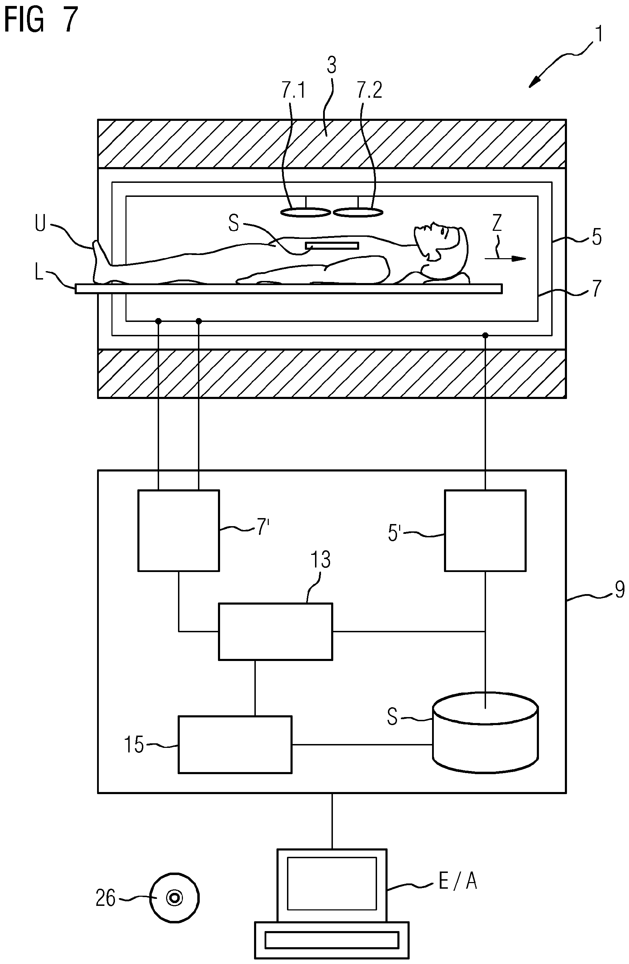

Figur 7 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 7 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht S stellt ein exemplarisches Zielvolumen des Untersuchungsobjekts dar, aus dem Messdaten aufgenommen werden sollen.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-sende/empfangs-Steuerung 7' gesteuerte Ströme an den HF-Spulen angelegt.

Weiterhin umfasst die Steuereinrichtung 9 eine Dephasier-Gradienten-Bestimmungseinheit 15, mit welcher ein für eine für die Aufnahme von Messdaten gewählte Pulssequenz um einen passenden erfindungsgemäßen dedizierten Dephasier-Gradienten ergänzt wird. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Verfahren zur Erzeugung von Messdaten eines Untersuchungsobjektes mittels Magnetresonanztechnik, umfassend die Schritte:
- Innerhalb einer Wiederholzeit (TR)
a) Einstrahlen eines RF-Anregungspulses (RFi, RFi+1, ...) in das Untersuchungsobjekt,
b) Schalten eines Schichtselektionsgradienten (GS1) während der RF-Anregungspuls (RFi, RFi+1, ...) eingestrahlt wird,
c) Schalten von weiteren Gradienten (GP1,GR2) zur Ortskodierung,
d) Aufnehmen eines nach dem RF-Anregungspuls (RFi, RFi+1, ...) erzeugten Echosignals (Ei) als Messdaten (MDi),
- Wiederholen der Schritte a) bis d) bis eine gewünschte Anzahl an RF-Anregungspulsen (RFi, RFi+1, ...) eingestrahlt wurde,
wobei jeweils ein zusätzlicher dedizierter Dephasier-Gradient (G*, GS*, GR*) geschaltet wird, derart, dass eine transversale Magnetisierung der durch einen RF-Anregungspuls (RFi, RFi+1, ...) anzuregenden Spins vor jedem eingestrahlten RF-Anregungspuls (RFi, RFi+1, ...) dephasiert ist.

2. Verfahren nach Anspruch 1, wobei die Erzeugung der Echosignale gemäß einem FISP-Sequenzschema erfolgt.

3. Verfahren nach einem der vorhergehenden Ansprüche, wobei der dedizierte Dephasier-Gradient (G*, GS*, GR*) in Schichtselektionsrichtung geschaltet wird.

4. Verfahren nach einem der vorhergehenden Ansprüche, wobei der dedizierte Dephasier-Gradient (G*, GS*, GR*) mindestens zwei Richtungen der Kodierrichtungen, Ausleserichtung (Frequenzkodierrichtung), in Phasenkodierrichtung und Schichtselektionsrichtung, geschaltet wird.

5. Verfahren nach einem der vorhergehenden Ansprüche, wobei die in den Wiederholungen eingestrahlten RF-Anregungspulse (RFi, RFi+1, ...) unterschiedliche Flipwinkel erzeugen, um den eine Magnetisierung der Spins in dem Untersuchungsobjekt durch dem eingestrahlten RF-Anregungspuls gekippt wird.

6. Verfahren nach einem der vorhergehenden Ansprüche, wobei die Dauer der Wiederholzeit TR variiert wird.

7. Verfahren nach einem der vorhergehenden Ansprüche, wobei das Aufnehmen (405) der Messdaten (MDi) entlang von kartesischen, spiralförmigen oder radialen k-Raumtrajektorien erfolgt.

8. Verfahren nach einem der vorhergehenden Ansprüche, wobei aus aufgenommenen Messdaten (MDi) jeweils Bilddaten (BDi) rekonstruiert werden.

9. Verfahren nach Anspruch 8, wobei die rekonstruierten Bilddaten (BDi) mittels eines Magnetresonanz-Fingerprinting-Verfahrens mit Vergleichsdaten (D) verglichen werden, um Parameterkarten (M) des Untersuchungsobjektes zu erstellen.

10. Verfahren nach einem der vorhergehenden Ansprüche, wobei der dedizierte Dephasier-Gradient (G*, GS*, GR*) durch Simulationen, insbesondere Bloch-Simulationen, bestimmt wird.

11. Verfahren nach Anspruch 10, wobei der durch Simulation bestimmte dedizierte Dephasier-Gradient (G*, GS*, GR*) experimentell überprüft und ggf. angepasst wird.

12. Verfahren nach einem der vorhergehenden Ansprüche, wobei der dedizierte Dephasier-Gradient (G*, GS*, GR*) experimentell bestimmt wird.

13. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Gradienten-Bestimmungseinheit (15), wobei die Steuereinrichtung (9) dazu ausgebildet ist, ein Verfahren nach einem der Ansprüche 1 bis 12 auf der Magnetresonanzanlage (1) auszuführen.

14. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 12 auszuführen, wenn das Programm in der Steuereinrichtung (9) der Magnetresonanzanlage (1) ausgeführt wird.

15. Elektronisch lesbarer Datenträger mit darauf gespeicherten elektronisch lesbaren Steuerinformationen, welche zumindest ein Computerprogramm nach Anspruch 14 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 12 durchführen.
